(19)

Europäisches Patentamt
European Patent Office
Office européen des brevets

(11) Veröffentlichungsnummer: **0 413 838 B1**

(12) **EUROPÄISCHE PATENTSCHRIFT**

(45) Veröffentlichungstag der Patentschrift: **02.03.94**

(51) Int. Cl.⁵: **H04N 5/445**, G06K 11/06, H03J 9/06

(21) Anmeldenummer: **89115455.1**

(22) Anmeldetag: **22.08.89**

(54) **Fernsehempfänger mit positionsgesteuerter Fernbedienung.**

(43) Veröffentlichungstag der Anmeldung:
**27.02.91 Patentblatt 91/09**

(45) Bekanntmachung des Hinweises auf die Patenterteilung:
**02.03.94 Patentblatt 94/09**

(84) Benannte Vertragsstaaten:
**DE FR GB IT NL**

(56) Entgegenhaltungen:
**US-A- 4 565 999**
**US-A- 4 745 402**

**I.E.E.E. TRANSACTIONS ON CONSUMER ELECTRONICS Band 34, Nr. 3, August 1988, Seiten 814-818, New York, USA; G. ZEISEL et al.: "An interactive menu-driven remote control unit for TV-receivers and VC-recorders"**

(73) Patentinhaber: **Deutsche ITT Industries GmbH**
**Hans-Bunte-Strasse 19**
**D-79108 Freiburg(DE)**

(72) Erfinder: **Heberle, Klaus, Dipl.-Ing.(FH)**
**Hinter den Eichen 42**
**D-7801 Reute(DE)**

**EP 0 413 838 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Moderne Fernsehempfänger weisen in steigendem Maß eine Vielzahl von Funktions- und Bedienungsmöglichkeiten auf, die den Umgang mit dem Fernsehempfänger technisch kompliziert machen, insbesondere bei der Fernbedienung. Eine Abhilfe schafft hier eine intelligente Bedienungsoberfläche im Fernsehempfänger, die im Dialogverfahren den Bedienenden in mehreren Schritten zur gewünschten Bedienungsfunktion führt. Eine wesentliche Rolle spielt hierbei das Anbieten einer Menu-Steuerung, die sich in Form unterschiedlicher Symbole oder Felder auf dem Bildschirm darstellen läßt, aus denen der Bedienende mittels einer Fernbedienungseinrichtung das gewünschte Menu-Programm auswählen kann. Dabei werden die Cursor-Bewegungen meist mittels sogenannter Positionstasten ausgeführt, die als Kipptasten für eine Vorwärts- und Rückwärtsbewegung ausgebildet sind.

Eine derartige Menu-Steuerung eines Fernsehempfängers ist beispielsweise in "IEEE Transactions on Consumer Electronics", Bd. 34, Nr. 3, August 1988, Seiten 814 bis 818 von G. Zeisel et al. unter dem Titel "An Interactive Menu-Driven Remote Control Unit for TV-Receivers and VC-Recorders" beschrieben. Der Fernbedienungsgeber weist hierbei nur eine einzige, relativ großflächige Cursor-Kombinations-Bewegungstaste auf, die durch exzentrisches Antippen die Cursorbewegung auslöst. Die Kombinationstaste ist dabei durch eine Vier-Richtungs-Kipptaste mechanisch realisiert. Beim Antippen auf der linken bzw. rechten Seite der Kombinationstaste wandert der Cursor auf dem Bildschirm nach links bzw. rechts. Entsprechend wandert der Cursor nach oben bzw. unten, wenn das Antippen auf der oberen bzw. unteren Tastenseite erfolgt, wobei die Kombinationstaste parallel zum senkrechten Bildschirm vorzustellen ist. Das jeweilige Schaltsignal der Kombinationstaste wird mittels einer elektronischen Schaltung im Geber als Richtungsbefehl codiert, verstärkt und einer Infrarot-Sendediode zugeführt. Die Ausrichtung des Fernbedienungsgebers bezüglich der Infrarot-Übertragungsstrecke beeinflußt lediglich die Reichweite, auf die Codierung selbst hat die Ausrichtung keinen Einfluß. Der Bildschirm des Fernsehempfängers zeigt eine Vielzahl von Menu-Feldern für feste und kontinuierlich vorgebbare Einstellungen, die über die Cursorbewegungen bedienbar sind. Wenn das gewünschte Menu-Feld erreicht wird, dann wird die Kombinationstaste zentral angetippt, wodurch ein weiterer codierter Befehl übertragen wird, der die jeweils vom Cursor angezeigte Bedienungsfunktion durchführt.

Das Auswählen des gewünschten Menu-Programms erfolgt besonders einfach mit einer positionsgesteuerten Fernbedienungseinrichtung, deren elektrooptische Ausführung beispielsweise in der EP-Patentanmeldung EP-A-0 377 055 (= ITT Case: H. Heberle 4) oder auch in US-A-4 745 402 beschrieben ist. Bei dieser Anordnung werden die empfangenen Intensitäten dreier optischer Strahlungsquellen ausgewertet, die drei Strahlungskeulen erzeugen, die in den drei Raumebenen jeweils unterschiedliche Intensitätsverteilungen aufweisen. Auf der Empfängerseite läßt sich daraus elektronisch ein horizontales und ein vertikales Bezugssignal ableiten, das etwa dem relativen Winkel zwischen der Längsachse des Fernbedienungsgebers und der Verbindungslinie zwischen dem Fernbedienungsgeber und dem Fernbedienungsempfänger entspricht. Da diese beiden Bezugssignale unabhängig von der Entfernung des Fernbedienungsgebers von der Empfangseinrichtung sind, lassen sich daraus durch Multiplikation mit einem festen Faktor Koordinatenwerte bestimmen, die direkt der Bildschirmfläche zuordenbar sind.

Durch diese positionsabhängige Steuerung steht dem Bedienenden neben den codierten Tastensignalen ein sehr wirkungsvolles Bedienungsmittel zur Verfügung, denn durch eine einfache Bewegung aus dem Handgelenk heraus, läßt sich der Cursor auf dem Bildschirm in beliebige Positionen bringen. Diesen unterschiedlichen Positionen sind unterschiedliche Menu-Felder zuzuordnen. Andererseits sind auch analoge Funktionen, beispielsweise die Lautstärke, auf diese Weise leicht einstellbar. Ein auf dem Bildschirm symbolisch dargestellter Schieberegler, beispielsweise ein Balken, wird als Lautstärkesteller durch den Cursor auf- oder zugesteuert.

Der Bedienungskomfort ist bei dieser Steuerung allerdings durch die Handunruhe gestört, denn die Handunruhe setzt der feinfühligen Cursor-Steuerung Grenzen. Es ist daher Aufgabe der in den Ansprüchen gekennzeichneten Erfindung, einen Fernsehempfänger mit positionsgesteuerter Fernbedienung anzugeben, der eine Vielzahl von Steuerfunktionen durch die Einbeziehung der Positionssignale vereinfacht oder gar erst ermöglicht, wobei der störende Einfluß der Handunruhe weitgehend beseitigt ist.

Die Erfindung und weitere Vorteile werden nun anhand der Figuren der Zeichnung näher erläutert:

Fig.1 zeigt in schematischer Ausführung als Blockschaltbild ein Ausführungsbeispiel der elektrooptischen Empfangseinrichtung für positionsgesteuerte Fernbedienungssignale,

Fig.2 zeigt schematisch als Blockschaltbild die Einblendschaltungen für den Bildschirm,

Fig.3a zeigt als Blockschaltbild eine Zoom-Einrichtung, die von den Positionssignalen gesteuert ist,

Fig.3b zeigt die Dehnung einer gespeicherten Bildzeile,

Fig.4a zeigt schematisch als Blockschaltbild eine Hardware-Realisierung der adaptiven Filterschaltung,

Fig.4b zeigt einige Zeitdiagramme zur Erläuterung der adaptiven Filterschaltung und

Fig.5 zeigt schematisch einige vorteilhafte Anwendungsmöglichkeiten der Positionssteuerung, wie sie sich dem Betrachter auf dem Bildschirm darbieten.

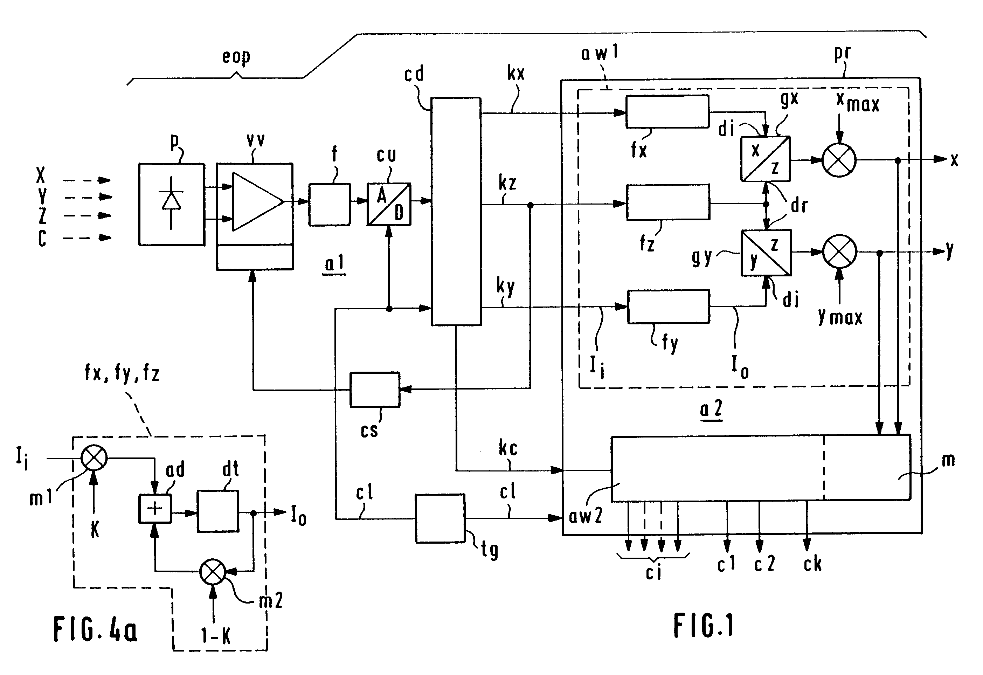

In Fig.1 ist schematisch die elektrooptische Empfangseinrichtung eop dargestellt, welche die drei unterschiedlichen Positionssignale X, Y, Z empfängt, die ein Fernbedienungsgeber nach der bereits genannten EP-Patentanmeldung EP-A-0 377 055 zusätzlich zu den codierten Fernbedienungssignalen C abgibt. Alle optischen Signale werden von einem Strahlungsdetektor p in elektrische Signale umgewandelt, die von einem variablen Verstärker verstärkt und über ein Rauschunterdrückungsfilter f einem Analog-Digitalumsetzer cu zugeführt werden. Dessen Ausgang speist eine Dekoderschaltung cd, welche die nacheinander empfangenen Positionssignale wieder trennt. Die Decoderschaltung kann beispielsweise eine Multiplexerschaltung sein, die vom Taktgenerator tg über den Takt cl gesteuert ist. Die Ausgangssignale der Decoderschaltung cd sind das x-, y- und z-Komponentensignal kx, ky, kz und als weiteres Komponentensignal die codierten Befehle kc.

Die erste Schaltungsanordnung a1 zur Verarbeitung der Positionssignale X, Y, Z enthält zur Auswertung der drei positionsbezogenen Komponentensignale kx, ky, kz eine erste Auswerteschaltung aw1 an deren Ausgang der gewünschte x- und y-Koordinatenwert x, y abgreifbar ist. Um die absoluten Intensitätsunterschiede infolge unterschiedlicher Bedienungsentfernungen auszugleichen, ist das z-Komponentensignal kz über ein Regelkreisfilter cs auf den Steuereingang des regelbaren Verstärkers vv zurückgeführt, dessen Verstärkung in einem weiten Bereich digital einstellbar ist.

Die erste Auswerteschaltung aw1 wertet die relativen Intensitätsunterschiede in horizontaler Richtung zwischen dem X- und Z-Positionssignal X, Y und die relativen Intensitätsunterschiede in vertikaler Richtung zwischen dem Y- und dem Z-Positionssignal Y, Z aus. Das Z-Positionssignal Z stellt dabei jeweils die Bezugsgröße dar. Die eigentliche Auswertung erfolgt anhand der digitalisierten Positionssignale, nämlich der drei Komponentensignale kx, ky, kz. Diese Signale sind einem programmierbaren Steuerprozesor pr zugeführt, der die erste Auswerteschaltung aw1 als Hardware-Schaltung oder noch einfacher als Software-Schaltung enthält, weil die erforderliche Verarbeitungsgeschwindigkeit im Vergleich zur Taktfrequenz des Steuerprozessors sehr niedrig ist.

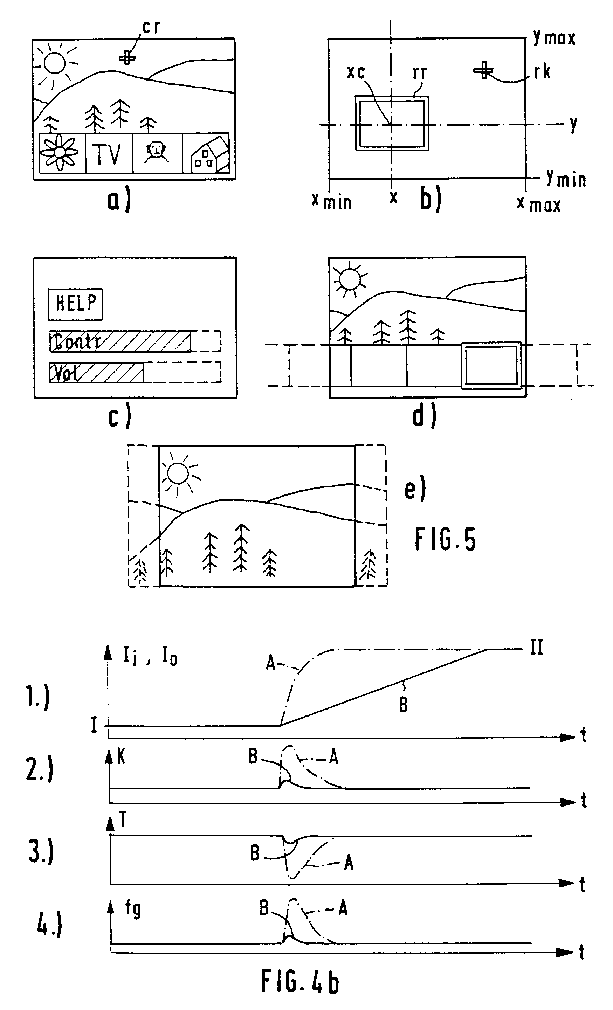

Zunächst werden alle drei Komponentensignale kx, ky, kz in jeweils einer adaptiven Filterschaltung fx, fy, fz gefiltert, deren jeweilige Grenzfrequenz fg (vgl. Fig.4b1) in einem weitem Bereich durch den jeweiligen Eingangs- und Ausgangswert li, lo der adaptiven Filterschaltung selbst bestimmt wird. (Eine ausführliche Beschreibung eines Ausführungsbeispieles dieser adaptiven Filterschaltung erfolgt im Zusammenhang mit der Beschreibung von Fig.4a). Der Ausgang der x- bzw. der z-Filterschaltung fx, fz ist auf den Dividend- bzw. Divisor-Eingang di, dr der x-Normierungsschaltung gx geführt. In gleicher Weise ist der Ausgang der y- bzw. der z-Filterschaltung fy, fz auf den Dividend- bzw. Divisor-Eingang di, dr der y-Normierungsschaltung gy geführt. Beide Normierungsschaltungen gx, gy sind Dividierschaltungen, deren Ausgangswerte den Wertbereich von 0 bis 1 umfassen. Wird dieser Wert mit dem höchsten Koordinatenwert x max, y max multipliziert, dann bildet das Ausgangssignal dieser Multiplikation bereits den gewünschten Koordinatenwert x, y. Es ist dabei in das freie Belieben gestellt, ob der ganze Koordinatenumfang auf den Bildschirm aufgeteilt sein soll oder ob der Bildschirm nur ein Teil des Koordinatenbereiches ausmacht, so daß der Cursor zwar unsichtbar, aber trotzdem definiert außerhalb des Bildschirmes bewegt werden kann. Dies ist für einige Bedienungsweisen durchaus interessant. Das Ausgangssignal der x-Normierungsschaltung gx bildet durch Multiplikation mit dem maximalen x-Koordinatenwert x max den x-Koordinatenwert x und der Ausgangswert der y-Normierungsschaltung gy bildet durch Multiplikation mit dem maximalen y-Koordinatenwert y max den gewünschten y-Koordinatenwert y.

Innerhalb des Steuerprozessors pr sind beide Koordinatenwerte x,y einer zweiten Schaltungsanordnung a2 zugeführt, die der Verarbeitung der codierten Befehle kc dient und die ferner auch eine Menu-Steuereinrichtung m enthält. Durch Decodierung werden aus den codierten Befehlen einzelne Befehle c1, c2, ..., ci gebildet, die weiteren, in Fig.1 nicht dargestellten Schaltungsteilen, zugeführt sind. Diese decodierten Befehle enthalten auch einen sogenannten Klick-Befehl ck, der mittels einer Taste im Fernbedienungsgeber ausgelöst wird und die Verriegelung der momentanen Cursor-Position bewirkt. Dies ist bei der Menu-Steuerung häufig der Fall.

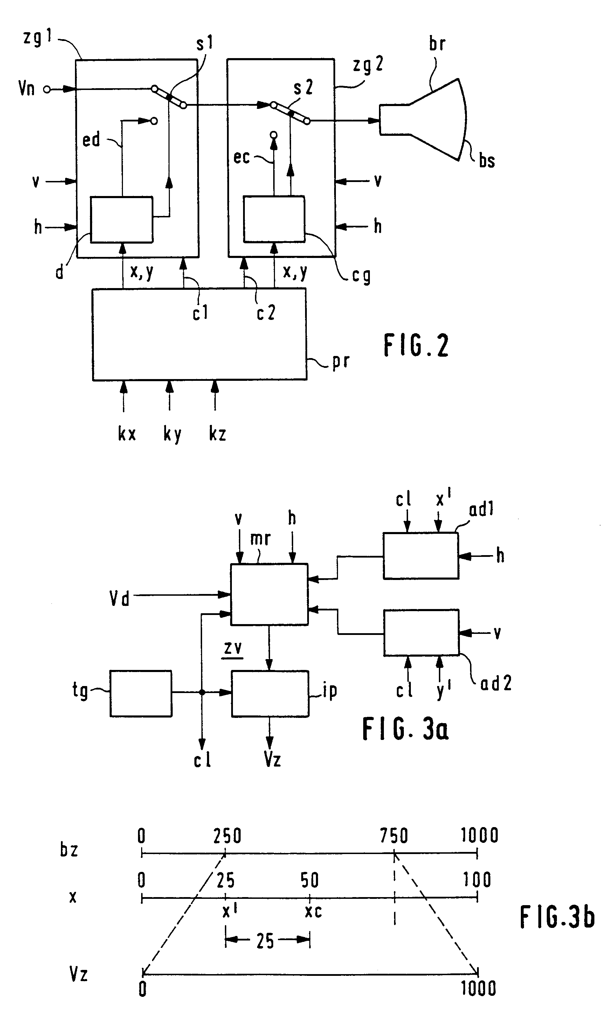

Fig.2 zeigt schematisch im Blockschaltbild die Schaltungseinrichtungen zur Einblendung von Zusatzsignalen im Fernsehbild. Dies ist über einen ersten oder einen zweiten Zeichengenerator zg1, zg2 möglich, die im Signalflußweg des normalen Videosignals Vn liegen und die mittels elektronischer Mehrebenenumschalter s1, s2 den Signalweg für die R-, G-, B-Signale umschalten. Die Umschaltung erfolgt dabei so rasch, daß zwischen zwei aufeinanderfolgenden Bildpunkten von der einen Signalquelle auf die andere umgeschaltet werden kann.

Für die Wiedergabe hat das Cursor-Signal ec aus dem Cursor-Generator cg die höchste Priorität, und wird daher im Signalflußweg unmittelbar vor der Bildröhre br eingespeist. Das Einblendsignal ed aus dem Display-Einblendsystem (= On Screen Display) d hat eine geringere Priorität und wird daher im Signalflußweg vor dem Cursor-Signal ec eingeblendet. Die beiden Zeichengeneratoren zg1, zg2 werden durch die beiden Koordinatenwerte x, y und ein vertikales und ein horizontales Taktsignal v, h gesteuert. Das Auslösen des ersten bzw. zweiten Zeichengenerators zg1, zg2 erfolgt mittels eines ersten bzw. zweiten Aktivierungssignals c1, c2 aus dem Steuerprozessor pr. Das vertikale bzw. das horizontale Taktsignal v, h bestimmt bekanntlich den Startzeitpunkt der vertikalen oder der horizontalen Rasterablenkung des Elektronenstrahls und entstammt der nichtdargestellten Ablenk-Synchronisierungsschaltung.

In Fig.3a ist schematisch eine Zoom-Einrichtung zo dargestellt, die einen Ausschnitt des gesendeten Fernsehbildes auf dem Bildschirm bs vergrößert wiedergibt. Zu diesem Zweck wird das digitalisierte Videosignal Vd in einen Vollbildspeicher mr eingeschrieben, wobei die Einleseadressen durch das horizontale und vertikale Taktsignal h, v und den System-Takt c1 aus dem Taktgenerator tg gesteuert sind. Für die Bildwiedergabe wird nur ein Teil der gespeicherten Daten ausgelesen, wobei die ausgelesenen Daten mittels einer Bildinterpolationsschaltung ip interpoliert werden. Wird beispielsweise bei der Auslesung jeder dritte Bildpunkt doppelt ausgelesen und die Werte entsprechend interpoliert, dann wird das Bild um ein Drittel in horizontaler Richtung vergrößert. Entsprechend muß dann der Inhalt jeder dritten Zeile ebenfalls doppelt ausgelesen und interpoliert werden, so daß auch das Bild in vertikaler Richtung um ein Drittel vergrößert wird. Somit ist mittels des erzeugten Zoom-Videosignals Vz der entsprechende Speicherteil formatfüllend auf dem Bildschirm bs dargestellt.

Die jeweiligen Ausleseadressen, insbesondere die modifizierten Startadressen werden dabei durch einen ersten und einen zweiten Adressengenerator ad1, ad2 gesteuert. Als Steuersignale sind dem ersten Adressengenerator ad1 dabei der System-Takt cl, ein modifizierter x-Koordinatenwert x′ und das horizontale Taktsignal h zugeführt. Dem zweiten Adressengenerator ad2 sind als Steuersignale der System-Takt cl, ein modifizierter y-Koordinatenwert y′ und das vertikale Taktsignal v zugeführt. Werden beispielsweise bei einer Einteilung des Bildschirms in 100 x-Koordinatenwerte, pro Bildzeile bz tausend Bildpunkte in tausend Adressen abgespeichert, dann wird bei einem eingestellten x-Koordinatenwert von fünfzig - die Cursor-Rahmen-Mitte xc steht also horizontal in der Mitte des Bildschirmes - ein mittlerer Speicherbereich ausgelesen. Bei einer linearen Vergrößerung um den Faktor 2 werden somit die horizontalen Bildpunkte von Adresse zweihundertfünfzig bis siebenhundertfünfzig ausgelesen. Die Startadresse für den horizontalen Auslesevorgang ist somit zweihundertfünfzig und ergibt sich aus der jeweiligen horizontalen Cursor-Position xc abzüglich eines Wertes von fünfundzwanzig für die halbe Rahmenbreite. Durch Multiplikation mit dem Maßstabfaktor, der hier zehn ist, kommt man zur gewünschten Startadresse. Fig.3b zeigt hierzu schematisch, wie sich im angegebenen Beispiel die Zeilendehnung der gespeicherten Bildzeile bz zu den x-koordinatenwerten x, zur modifizierten Cursor-Position x′ und zum gedehnten Zoom-Videosignal Vz verhält.

In Fig.4a ist das adaptive Filter fx, fy, fz dargestellt, das auf besonders vorteilhafte Weise die Handunruhe bei der Cursor-Einstellung beseitigt. Die Handunruhe ist dabei im Unterschied zu Störungen auf der optischen Übertragungsstrecke zu sehen, die durch Signalrauschen oder Störsignale, z.B. die Lichtwechselfrequenz, bedingt sind. Diese Handunruhe ist eine niederfrequente Zitterfrequenz von einigen Hertz, wobei die Auslenkung in der Regel klein ist. Bei einem normalen Tiefpaßfilter, das diese Frequenz unterdrückt, würde der Cursor nur unangenehm träge der Einstellung folgen. Die adaptive Filterschaltung ist in Fig.4a als Hardware-Schaltung schematisch dargestellt. Die Realisierung erfolgt jedoch zweckmäßigerweise als Software-Anordnung innerhalb des Prozessors pr, weil die Änderungsgeschwindigkeit der zu verarbeitenden Signale langsam im Vergleich zur Frequenz des Taktes cl ist.

Das Eingangssignal Ii des adaptiven Filters wird mittels einer ersten Multiplizierschaltung m1 mit dem variablen Filterkoeffizient K multipliziert und das Ausgangssignal dieser Multiplikation einem Addierer ad zugeführt. Der Ausgang dieses Addierers speist ein Zeitglied dt, das den Wert mindestens um die Periodendauer für einen vollständigen Abtastzyklus der drei Positionssignalen X, Y, Z verzögert und an dessen Ausgang der Filter-Ausgangswert Io abgreifbar ist, der somit synchron zum Eingangswert Ii ist. Der zweite Eingang des Addierers ad ist vom Ausgang eines zweiten Multiplizierers m2 gespeist, dessen einem Eingang das Ausgangssignal Io und dessen anderem Eingang ein Gewichtungsfaktor 1-K zugeführt ist. Der variable Filterkoeffizient K liegt im Bereich zwischen null und eins, wobei kleine Werte von K eine niedere Grenzfrequenz und große Werte von K eine hohe Grenzfrequenz bewirken.

Für die Software-Ausführung der adaptiven Filterschaltung ist die nachfolgende erste Bemessungsregel vorteilhafter, weil sich für den nachfolgenden Ausgangswert Io + 1 ein einfacher Algorithmus darstellen läßt:

$$Io + 1 = (1\text{-}K)Io + KIi.$$

In beiden Fällen ist der Filterkoeffizient K ein Bewertungsfaktor, der den Wert eins nicht übersteigt und der besonders vorteilhaft aus dem momentanen Eingangswert Ii und dem synchronen Ausgangswert Io nach folgender zweiten Bemessungsregel gebildet ist:

$$K = (K\ max - K\ min)\ Absolut\ (Ii\text{-}Io)/I\ max + K\ min,$$

wobei die Werte K max und K min die vorzugebende untere bzw. obere Bereichsgrenze für den Filterkoeffizient K darstellen. Durch Festlegung dieser im Steuerprozeßor pr gespeicherten Werte, wird der Variationsbereich der Grenzfrequenz für das adaptive Filter vorgegeben. Der Wert I max ist die vorzugebende obere Bereichsgrenze des jeweiligen Filter-Eingangswertes Ii und hängt im wesentlichen vom Auflösungsbereich des Analog-Digitalumsetzers cu ab. In Fig.4b sind zur Erläuterung der adaptiven Filterschaltung fx, fy, fz einige Zeitdiagramme dargestellt.

In Fig.4b1 ist der zeitliche Verlauf des Eingangs- und Ausgangswertes Ii, Io gezeigt und zwar wird im Fall A der Cursor schnell von einer ersten Position I in eine weitabliegende zweite Position II gebracht. Im Fall B wird der Cursor langsam von der ersten in die zweite Position I, II bewegt. In beiden Fällen A, B ist der Ausgangswert Io etwa gleich dem Eingangswert Ii. Dies ermöglicht der variable Filterkooefizient K, der im Diagramm 4b2 dargestellt ist. Der Wert des Filterkoeffizienten K ist linear vom Absolutwert der Differenz des momentanen Ein- und Ausgangswertes Ii, Io abhängig. Im Fall A springt er von einem niederen Wert während der raschen Bewegungsphase auf einen hohen Wert und bringt dabei die Filterzeitkonstante T auf einen niederen Wert, vgl. Diagramm 4b3. Die zugehörige Grenzfrequenz fg ist im Diagramm 4b4 angegeben. Sie springt während der raschen Bewegungsphase des Cursors von einem niederen Wert auf einen hohen Wert und sinkt mit zunehmender Annäherung des abgebildeten Cursors (Istwert) an seinen eingestellten Positionswert (Sollwert) wieder ab.

Kleine aber rasche Zittervorgänge werden somit durch die niedere Grenzfrequenz des adaptiven Filters wirksam unterdrückt, während schnell erfolgende große Cursor-Bewegungen das adaptive Filter für höhere Frequenzen durchlässig machen. Damit folgt der Cursor leicht jeder Handbewegung und läßt sich andererseits feinfühlig auf dem Bildschirm einstellen.

In Fig.5 sind schematisch einige Möglichkeiten dargestellt wie aus der Sicht des Bedienenden die Fernbedienung eines Fernsehempfängers erleichtert wird. Fig.5a zeigt beispielsweise ein Fernsehbild, in dem die verkleinerten Bilder von vier weiteren Programmen in vier Menu-Feldern eingeblendet sind. Indem der Cursor cr auf eines dieser Menu-Felder geführt wird, kann durch Betätigung der Klick-Taste das entsprechende Programm als Hauptprogramm umgeschaltet werden.

In Fig.5b ist der Cursor auf dem Bildschirm einmal als Kreuz rk und einmal als Rechteckrahmen rr dargestellt. Im Falle des Rechteckrahmens gibt dessen Mitte xc die jeweilige Cursor-Position xy an. Der Bereich des Bildschirms ist dabei durch Minimum und Maximum-Koordinatenwerte definiert; die Koordinatenwerte außerhalb des Bildschirms können jedoch auch noch definiert sein. Mittels des verschiebbaren Rechteckrahmens rr kann beispielsweise die Einblendposition eines in einem Bildausschnitt eingefügten Kleinbildes, z.B. ein zusätzliches Programm, auf dem Bildschirm frei gewählt werden. Mittels eines Klick-Befehls ck wird das Kleinbild gleichsam an den Cursor "geheftet" und mittels des nächsten Klick-Befehls ck an der gewünschten Position wieder vom Cursor "losgelassen" Der Steuerprozessor pr verändert bei dieser Betriebsweise über den x- und den y-Koordinatenwert x, y des Cursors die jeweiligen Einleseadressen des Groß- und des Kleinbildes in einem Bildspeicher mr.

Fig.4c zeigt einen Bildschirm mit symbolartigen Darstellungen, die vom ersten Zeichengenerator zg1 stammen. Die unteren Balken sind in der Länge beweglich und stellen symbolische Schieberegler für die Lautstärke ( = Vol) und den Kontrast = Contr) dar. Das darüberliegende Menu-Feld ( = HELP) löst bei Ansteuerung eine "Hilfe"-Funktion aus, die den Bedienenden im Dialogverfahren zur gewünschten Bedienungsfunktion hinführt.

Fig.5d stellt eine Programmwahl mit Hilfe des Cursors dar, wobei die unterschiedlichen Programme wie in Fig.5a als verkleinerte Bilder eingeblendet sind, jedoch gleichsam eine über den Bildschirm hinauslaufende Kette bilden. Mit dem Cursor und dem Klick-Befehl wird diese Kette an beliebiger Stelle angefaßt und solange hin und hergeschoben, bis das gewünschte Programm im eingeblendeten Rahmen erscheint. Durch einen weiteren Klick-Befehl wird dieses Programm dann als Hauptprogramm übernommen.

Fig.5e zeigt schließlich ein Programm, das in einem vom Bildschirmformat abweichenden Seitenverhältnis ausgestrahlt und so nur teilweise abgebildet wird. Rechts und links vom Bildschirm wird ein Teil des Bildes nicht wiedergegeben. Durch einfaches Schwenken des Fernbedienungsgebers kann der wiedergegebene Ausschnitt je nach Wunsch einfach nach rechts oder links verschoben werden, wenn der dortige Bildinhalt wiedergegeben werden soll. Ähnlich verhält es sich, wenn der Fernsehempfänger mit einer Zoom-Einrichtung versehen ist, dann kann durch einfaches Schwenken des Fernbedienungsgebers der jeweils zu vergrößernde Ausschnitt auf einfachste Weise bestimmt werden.

Für die Wiedergabe von Filmen, die im Kino-Breitleinwandverfahren hergestellt sind, die also ein erheblich vom 4:3 Seitenverhältnisstandard abweichendes Bildformat haben, weist der Bildschirm bei der Wiedergabe üblicherweise oben und unten einen schwarzen Streifen auf. Mittels einer Zoom-Einrichtung, die einen vorgegebenen ersten Vergrößerungsfaktor aufweist, kann das wiedergegebene Fernsehbild auf eine bildschirmfüllende Zeilenzahl gebracht werden, wobei der zu vergrößernde Bildausschnitt lediglich durch den x-Koordinatenwert x der positionsgesteuerten Fernbedienungseinrichtung, also ohne den Klick-Befehl ck, bestimmt ist. Der Cursor-Generator cg bildet dabei auch keinen Rechteckrahmen rr auf dem Bildschirm bs ab. Ein ähnlicher Fall liegt vor, wenn das empfangene Fernsehbild in seinem Rasteraufbau vom üblichen 4:3 Seitenverhältnisstandard abweicht. Die entsprechenden Fernsehsignale müssen durch eine geeignete Empfangs- und Decodereinrichtung selbstverständlich erst in das Basisband umgesetzt werden und ein geeigneter Bildspeicher mr muß zur Verfügung stehen. In diesem Fall weist die Zoom-Einrichtung einen festen zweiten Vergrößerungsfaktor auf, der das empfangene Fernsehbild auf eine bildschirmfüllende Zeilenzahl bringt. Der zu vergrößernde Bildausschnitt ist dann lediglich durch den x-Koordinatenwert x ohne Klick-Befehl ck bestimmt. Auf dem Bildschirm wird natürlich kein Rechteckrahmen rr durch den Cursorgenerator cg erzeugt. Der auszuwählende Bildausschnitt wird lediglich durch horizontales Schwenken des Fernbedienungsgebers eingestellt.

Ein weiterer Sonderfall der Zoom-Einrichung zo ist der Fall, daß das empfangene Fernsehbild in seinem Rasteraufbau ebenfalls vom üblichen 4:3 Seitenverhältnisstandard abweicht, jedoch in der Zeilenzahl gleich ist; eine doppelte Zeilenzahl ist ebenso zulässig. In diesem speziellen Fall ist statt des Vollbildspeichers mr in der Zoom-Einrichtung zo lediglich ein Zeilenspeicher erforderlich, der jeweils den Inhalt einer empfangenen Zeile speichert und ein Ausschnitt dieser Zeile auf die gesamte Bildschirmbreite mittels einer Interpolationsschaltung dehnt. Der Vergrößerungsfaktor der Zoom-Einrichtung zo hat in diesem speziellen Fall den Wert 1.

**Patentansprüche**

**1.** Fernsehempfänger mit positionsgesteuerter Fernbedienung und mit folgenden Schaltungseinrichtungen:
- einer elektrooptischen Empfangseinrichtung (eop) für Fernbedienungssignale, die aus den empfangenen Fernbedienungssignalen einen (horizontalen) x- und einen (vertikalen) y-Koordinatenwert (x bzw. y) sowie codierte Befehle (kc) bildet,
- einer Menu-Steuereinrichtung (m), die vom x- und y-Koordinatenwert (x, y) und den codierten Befehlen (kc) gesteuert ist,
- ein in der Menu-Steuerschaltung (m) enthaltener Cursor-Generator (cg) erzeugt auf den Bildschirm (bs) ein auffallendes Bildzeichen (cr; rr; rk), dessen Position durch den x- und y-Koordinatenwert (x, y), gesteuert ist, wobei der momentane Wert des x- und des y-Koordinatenwertes (x, y) als Cursor-Position (x, y) durch Auslösung eines Klick-Befehls (ck) abgespeichert wird und
- ein mit der Menu-Steuerschaltung (m) gekoppeltes Display-Einblendsystem ( = On Screen Display) (d) liefert eine symbolartige Darstellung von festen und/oder kontinuierlich einzustellenden Betriebsparametern auf dem Bildschirm (bs), wobei mittels der Cursor-Position (x, y) der gewünschte Betriebsparameter einzustellen ist,

gekennzeichnet durch folgende Merkmale:
- die positionsgesteuerte Fernbedienung erzeugt geberseitig drei positionsabhängige Fernbedienungssignale ( = Positionssignale) (X, Y, Z), die von der relativen, manuell vorgegebenen Ausrichtung des Fernbedienungsgebers zum Fernsehempfänger abhängig sind und die von der elektrooptischen Empfangseinrichtung (eop) mittels einer Schaltungsanordnung (a1, a2) in den x- und y-Koordinatenwert (x bzw. y) umgesetzt werden, und
- im Signalpfad der drei in elektrische Komponentensignale (kx, ky, kz) umgewandelten Positionssignale (X, Y, Z) ist jeweils eine adaptive Filterschaltung (fx, fy, fz) zur Unterdrückung höherer Frequenzanteile des jeweiligen Komponentensignals (kx, ky, kz) eingefügt, wobei die jeweilige Grenzfrequenz durch die zugehörigen Komponentensignale gesteuert wird.

**2.** Fernsehempfänger nach Anspruch 1, dadurch gekennzeichnet, daß die Programme der angebotenen Empfangskanäle in verkleinerter Form jeweils in einem Bildausschnitt des Bildschirms (bs) mittels einer bekannten Mehrfachbilddarstellung wiedergegeben sind, wobei der Bildausschnitt für das jeweilige Programm als Menufeld dient, das mittels der Cursor-Position (xy) als Hauptprogramm auszuwählen ist.

**3.** Fernsehempfänger nach Anspruch 1, dadurch gekennzeichnet, daß der Cursor-Generator (cg) auf dem Bildschirm einen Rechteckrahmen (rr) erzeugt, dessen Position durch den x- und den y-Koordinatenwert (x, y) gesteuert ist.

**4.** Fernsehempfänger nach Anspruch 2 und 3, gekennzeichnet durch folgende Merkmale:
- mittels des verschiebbaren Rechteckrahmens (rr) ist die Einblendposition eines in einem Bildausschnitt eingefügten zusätzlichen Programms auf dem Bildschirm frei wählbar, indem über den x- und y-Koordinatenwert (x, y) die jeweiligen Einleseadressen des Groß- und des Kleinbildes in einem Bildspeicher (mr) bestimmt sind und
- mittels der Cursor-Position (xy) ist die endgültige Einblendposition festgelegt.

**5.** Fernsehempfänger nach Anspruch 3, gekennzeichnet durch folgende Merkmale:
- mittels des verschiebbaren Rechteckrahmens (rr) wird auf dem Bildschirm (bs) derjenige Bildausschnitt bestimmt, der mittels einer bekannten Zoom-Einrichtung (zo) zu vergrößern ist,
- die Zoom-Einrichtung (zo) enthält einen Vollbildspeicher (mr) für den gesamten Bildinhalt und eine Bildinterpolationsschaltung (ip), wobei
- die Startadressen für das Auslesen des zu vergrößernden Bildausschnittes durch die Cursor-Position (xy) bestimmt sind.

**6.** Fernsehempfänger mit einer Zoom-Einrichtung (zo) nach Anspruch 5, dadurch gekennzeichnet, daß die Zoom-Einrichtung (zo) einen vorgegebenen ersten Vergrößerungsfaktor aufweist, der ein im Kino-Breitleinwandverfahren ausgestrahltes Fernsehbild auf eine bildschirmfüllende Zeilenzahl bringt, wobei der zu vergrößernde Bildausschnitt lediglich durch den x-Koordinatenwert (x) ohne den Klick-Befehl (ck) bestimmt ist und wobei der Cursor-Generator (cg) keinen Rechteckrahmen (rr) auf den Bildschirm (bs) wiedergibt.

**7.** Fernsehempfänger mit einer Zoom-Einrichtung (zo) nach Anspruch 5, gekennzeichnet durch folgende Merkmale:
- das empfangene Fernsehbild weicht in seinem Rasteraufbau von üblichen 4:3 Seitenverhältnisstandard ab,
- die Zoom-Einrichtung weist einen festen zweiten Vergrößerungsfaktor auf, der das empfangene Fernsehbild auf eine bildschirmfüllende Zeilenzahl bringt,
- der zu vergrößernde Bildausschnitt ist lediglich durch den x-Koordinatenwert (x) ohne Klick-Befehl (ck) bestimmt und
- der Cursor-Generator (cg) erzeugt auf dem Bildschirm (bs) keinen Rechteckrahmen (rr).

**8.** Fernsehempfänger mit einer Zoom-Einrichtung (zo) nach Anspruch 6, gekennzeichnet durch folgende Merkmale:
- das empfangene Fernsehbild weicht in seinem Rasteraufbau vom üblichen 4:3 Seitenverhältnisstandard ab, weist jedoch die gleiche Zeilenanzahl pro Bild auf,
- statt des Vollbildspeichers (mr) ist nur ein Zeilenspeicher erforderlich, der jeweils den Inhalt einer empfangenen Zeile speichert, und
- der Vergrößerungsfaktor der Zoom-Einrichtung (zo) weist den Wert Eins auf.

**9.** Fernsehempfänger mit positionsgesteuerter Fernbedienung und mit folgenden Schaltungseinrichtungen:
- einer elektrooptischen Empfangseinrichtung (eop) für Fernbedienungssignale mit mindestens einem optischen Strahlungsdetektor (p), einem Vorverstärker (vv), einer Decoderschaltung (cd), einer ersten Auswerteschaltung (aw1), die als Ausgangssignale einen x- und einen y-Koordinatenwert (x bzw. y) liefert, und mit einer zweiten Auswerteschaltung (aw2), die als Ausgangssignale decodierte Fernbedienungssignale (ci, c1, c2, ck) liefert,

<u>gekennzeichnet durch folgende Merkmale:</u>
- die positionsgesteuerte Fernbedienung erzeugt geberseitig drei positionsabhängige Fernbedienungssignale (= Positionssignale) (X, Y, Z), die von der relativen, manuell vorgegebenen Ausrichtung des Fernbedienungsgebers zum Fernsehempfänger abhängig sind, und
- im Signalpfad der drei in elektrische Komponentensignale (kx, ky, kz) umgewandelten Positionssignale (X, Y, Z) ist jeweils eine adaptive Filterschaltung (fx, fy, fz) zur Unterdrückung höherer Frequenzanteile des jeweiligen Komponentensignals (kx, ky, kz) eingefügt, wobei die jeweilige Grenzfrequenz durch die zugehörigen Komponentensignale gesteuert wird.

**10.** Fernsehempfänger nach Anspruch 9, gekennzeichnet durch folgende Merkmale:
- die Grenzfrequenz der adaptiven Filterschaltung (fx, fy, fz) im jeweiligen Signalpfad ist vom Eingangs- und Ausgangswert der jeweiligen, adaptiven Filterschaltung abhängig,
- aus einem momentanen Eingangswert Ii und einem synchronen Ausgangswert Io der jeweiligen, adaptiven Filterschaltung (fx, fy, fz) ist der nachfolgende Ausgangswert Io + 1 nach folgender erster Bemessungsregel gebildet:

  $Io + 1 = (1-K)Io + KIi,$

- der Filterkoeffizient K ist ein Bewertungsfaktor, der den Wert eins nicht übersteigt und der aus dem momentanen Eingangswert Ii und dem zeitgleichen Ausgangswert Io nach folgender zweiter Bemessungsregel gebildet ist:

  $K = (K\ max - K\ min) * Absolut(Ii - Io)/I\ max + K\ min,$

- die Werte K max und K min stellen die vorzugebende untere bzw. obere Bereichsgrenze für den Filterkoeffizient K dar,
- der Wert I max ist die vorzugebende obere Bereichsgrenze des jeweiligen Filter-Eingangswertes Ii und
- das Zeitintervall zwischen dem synchronen und dem nachfolgenden Ausgangswert Io, Io + 1 der jeweiligen, adaptiven Filterschaltung (fx, fy, fz) beträgt mindestens die Periodendauer eines vollständigen Abtastzykluses der drei Positionssignale (X, Y, Z).

## Claims

**1.** A television receiver with position-dependent remote control and with the following circuit devices:
- an electrooptical receiving device (eop) for receiving remote-control signals which forms a (horizontal) x-coordinate value (x) and a (vertical) y-coordinate value (y) as well as coded commands (kc) from the received remote-control signals,
- a menu controller (m) controlled by the x- and y-coordinate values (x, y) and the coded commands (kc),
- a cursor generator (cg) contained in the menu controller (m) generates on the screen (bs) a distinctive pictorial symbol (cr; rr; rk) whose position is controlled by the x- and y-coordinate values (x, y), with the instantaneous x- and y-coordinate values (x, y) being stored as the cursor position (x, y) by initiating a click command (ck), and
- an on-screen display system (d) coupled to the menu controller (m) provides a symbolic display of fixed and/or continuously adjustable operating parameters on the screen (bs), the desired operating parameter having to be adjusted by means of the cursor position (x, y),

characterized by the following features:
- The position-dependent remote control generates on the transmitter side three position-dependent remote-control signals ( = position signals) (X, Y, Z) which are dependent on the relative, manually predetermined orientation of the remote-control transmitter with respect to the television receiver and which are converted to the x-and y-coordinate values (x, y) by means of a circuit arrangement (a1, a2) in the electrooptical receiving device (eop), and
- each of the signal paths for the three position signals (X, Y, Z) converted to electric component signals (kx, ky, kz) contains an adaptive filter circuit (fx, fy, fz) for suppressing higher frequency components of the respective component signal (kx, ky, kz), the respective cutoff frequency being controlled by the associated component signals.

**2.** A television receiver as claimed in claim 1, characterized in that the programs of the channels being offered are reproduced on the screen (bs) in small inset pictures using a conventional multipicture display technique, with the small picture for the respective program serving as a menu field which can be selected as the main program by means of the cursor position (xy).

**3.** A television receiver as claimed in claim 1, characterized in that the cursor generator (cg) generates on the screen a rectangular frame (rr) whose position is controlled by the x- and y-coordinate values (x, y).

**4.** A television receiver as claimed in claims 2 and 3, characterized by the following features:
- By means of the movable rectangular frame (rr), the on-screen display position of an additional program in an inset picture is freely selectable on the screen, the respective write addresses of the large and small pictures in a frame memory (mr) being determined via the x- and y-coordinate values (x, y), and
- by means of the cursor position (xy), the final on-screen display position is determined.

**5.** A television receiver as claimed in claim 3, characterized by the following features:
- By means of the movable rectangular frame (rr), that picture detail is determined on the screen (bs) which is to be enlarged by means of a conventional zoom facility (zo);
- the zoom facility (zo) contains a frame memory (mr) and a picture interpolation circuit (ip), and
- the start addresses for reading the picture detail to be enlarged are determined by the cursor position (xy).

**6.** A television receiver comprising a zoom facility (zo) as claimed in claim 5, characterized in that the zoom facility (zo) has a predetermined first enlargement factor which brings a television picture transmitted in a wide-screen motion picture system to a number of lines giving a full-screen display, with the picture portion to be enlarged being determined only by the x-coordinate value (x), i.e., without the click command (ck), and the cursor generator (cg) generating no rectangular frame (rr) on the screen (bs).

**7.** A television receiver comprising a zoom facility (zo) as claimed in claim 5, characterized by the following features:
- The received television picture does not have the standard 4:3 aspect ratio;
- the zoom facility has a fixed second enlargement factor which brings the received television picture to a number of lines giving a full-screen display;
- the picture portion to be enlarged is determined only by the x-coordinate value (x), i.e., without the click command (ck), and
- the cursor generator (cg) generates no rectangular frame (rr) on the screen (bs).

**8.** A television receiver comprising a zoom facility (zo) as claimed in claim 6, characterized by the following features:
- The received television picture does not have the standard 4:3 aspect ratio but contains the standard number of lines;
- instead of the frame memory (mr), only a line memory is necessary which stores the contents of a received line, and
- the enlargement factor of the zoom facility (zo) is unity.

**9.** A television receiver with position-dependent remote control and with the following circuit devices:
- an electrooptical receiving device (eop) for receiving remote-control signals, comprising at least one optical radiation detector (p), a preamplifier (vv), a decoder circuit (cd), a first evaluating circuit (aw1) which provides an x-coordinate value (x) and an y-coordinate value (y) as output signals, and a second evaluating circuit (aw2) which provides decoded remote-control signals (ci, c1, c2, ck) as output signals,

characterized by the following features:
- The position-dependent remote control generates on the transmitter side three position-dependent remote-control signals (= position signals) (X, Y, Z) which are dependent on the relative, manually predetermined orientation of the remote-control transmitter with respect to the television receiver, and
- each of the signal paths for the three position signals (X, Y, Z) converted to electric component signals (kx, ky, kz) contains an adaptive filter circuit (fx, fy, fz) for suppressing higher frequency components of the respective component signal (kx, ky, kz), the respective cutoff frequency being controlled by the associated component signals.

**10.** A television receiver as claimed in claim 9, characterized by the following features:
- The cutoff frequency of the adaptive filter circuit (fx, fy, fz) in the respective signal path is dependent on the input and output values of the respective adaptive filter circuit;
- from an instantaneous input value Ii and a synchronous output value Io of the respective adaptive filter circuit (fx, fy, fz), the next output value Io + 1 is formed according to the following first design rule:

$Io + 1 = (1-K)Io + KIi$;

- the filter coefficient K is a weighting factor which is not greater than unity and is formed from the instantaneous input value Ii and the synchronous output value Io according to the following second design rule:

  $K = (K\ max - K\ min) * absolute\ (Ii - Io)/I\ max + K\ min$;

- the values K max and K min represent the lower and upper limits, respectively, of the filter coefficient K, which have to be preset;
- the value I max is the upper limit of the respective filter input value Ii, which limit has to be preset, and
- the time interval between the synchronous output value Io and the next output value Io + 1 of the adaptive filter circuit (fx, fy, fz) is at least equal to one complete sampling period of the three position signals (X, Y, Z).

## Revendications

**1.** Récepteur de télévision à télécommande positionnelle, comportant les éléments de circuit suivants :
   - un dispositif de réception électro-optique (eop) pour des signaux de télécommande, qui forme, à partir des signaux de télécommande reçus, une valeur de coordonnée x (horizontale) et une valeur de coordonnée y (verticale) (x ou y) ainsi que des instructions codées (kc),
   - un dispositif de commande de menu (m), qui est commandé par les valeurs de coordonnées x et y (x, y) et par les instructions codées (kc),
   - un générateur de curseur (cg), qui est contenu dans le circuit de commande de menu (m), produit sur l'écran (bs) un caractère d'image voyant (cr; rr; rk), dont la position est commandée par les valeurs de coordonnées x et y (x, y), la valeur instantanée des valeurs de coordonnées x et y (x, y) étant mémorisée en tant que position de curseur (x, y) par le déclenchement d'une instruction de clic (ck), et
   - un système d'insertion d'affichage ( = On Screen Display) (d), couplé au circuit de commande de menu (m), délivre une représentation en forme de symboles de paramètres de fonctionnement fixes et/ou devant être réglés continûment, sur l'écran (bs), le paramètre de fonctionnement désiré devant être réglé au moyen de la position de curseur (x, y),

   caractérisé par les caractéristiques suivantes :
   - la télécommande positionnelle produit, côté transmetteur, trois signaux de télécommande dépendant de la position ( = signaux de position) (X, Y, Z), qui dépendent de l'orientation relative, prédéterminée manuellement, du transmetteur de télécommande en direction du récepteur de télévision et qui sont convertis par le dispositif de réception électro-optique (eop), au moyen d'un montage (a1, a2), en des valeurs de coordonnées x et y (x et y), et
   - dans la voie de transmission des trois signaux de position (X, Y, Z), convertis en des signaux de composantes électriques (kx, ky, kz), est inséré respectivement un circuit de filtre adaptatif (fx, fy, fz) servant à supprimer des composantes de fréquences supérieures de la composante respective de signal (kx, ky, kz), la fréquence limite respective étant commandée par les composantes associées de signaux.

**2.** Récepteur de télévision selon la revendication 1, caractérisé en ce que les programmes des canaux de réception proposés sont reproduits sous forme réduite respectivement dans une zone de l'image de l'écran (bs) au moyen d'une représentation connue d'images en plusieurs couleurs, la zone de l'image étant utilisée pour le programme respectif en tant que zone de menu, qui doit être sélectionnée en tant que programme principal au moyen de la position (xy) du curseur.

**3.** Récepteur de télévision selon la revendication 1, caractérisé en ce que le générateur de curseur (cg) produit, sur l'écran, un cadre rectangulaire (rr), dont la position est commandée par les valeurs de coordonnées x et y (x, y).

**4.** Récepteur de télévision selon les revendications 2 et 3, caractérisé par les caractéristiques suivantes :
   - à l'aide du cadre rectangulaire déplaçable (rr), la position d'insertion d'un programme supplémentaire inséré dans une zone de l'image, sur l'écran, peut être choisie librement par le fait que les adresses respectives d'enregistrement de la grande image et de la petite image dans une mémoire d'images (mr) sont déterminées par l'intermediaire des valeurs de coordonnées x et y (x, y), et
- la position finale d'insertion est fixée au moyen de la position (xy) du curseur.

**5.** Récepteur de télévision selon la revendication 3, caractérisé par les caractéristiques suivantes :
- au moyen du cadre rectangulaire déplaçable (rr), on détermine sur l'écran (bs) la zone de l'image, qui doit être agrandie au moyen d'un dispositif de zoom connu (zo),
- le dispositif de zoom (zo) contient une mémoire d'images complète (mr) pour l'ensemble du contenu d'image et un circuit d'interpolation d'images (ip),
- les adresses de départ pour la lecture de la zone d'image devant être agrandie sont déterminées par la position (xy) du curseur.

**6.** Récepteur de télévision comportant un dispositif de zoom (zo) selon la revendication 5, caractérisé en ce que le dispositif de zoom (zo) possède un premier facteur de grandissement prédéterminé, qui place une image de télévision émise dans le procédé à écran de projection cinématographique large, sur un nombre de lignes qui remplit l'écran, la zone de l'image devant être agrandie étant déterminée uniquement par la valeur de coordonnée x (x) sans l'instruction de clic (ck), et le générateur de curseur (cg) ne reproduisant aucun cadre rectangulaire (rr) sur l'écran (bs).

**7.** Récepteur de télévision comportant un dispositif de zoom (zo) selon la revendication 5, caractérisé par les caractéristiques suivantes :
- la constitution de la trame de l'image de télévision reçue diffère du standard usuel de rapport des côtés 4:3,
- le dispositif de zoom possède un second facteur de grandissement fixe, qui place l'image de télévision reçue sur un nombre de lignes remplissant l'écran,
- la zone de l'image devant être agrandie est déterminée uniquement par la valeur de coordonnée x (x) sans instruction clic (ck), et
- le générateur de curseur (cg) ne produit aucun cadre rectangulaire (rr) sur l'écran (bs).

**8.** Récepteur de télévision comportant un dispositif de zoom (zo) selon la revendication 6, caractérisé par les caractéristiques suivantes :
- la structure de la trame de l'image de télévision reçue diffère du standard usuel de rapport des côtés 4:3, mais possède le même nombre de lignes par image,
- à la place de la mémoire d'images complète (mr), seule est nécessaire une mémoire de lignes, qui mémorise respectivement le contenu d'une ligne reçue, et
- le facteur de grandissement du dispositif de zoom (zo) possède la valeur "I".

**9.** Récepteur de télévision à télécommande positionnelle comportant les éléments de circuit suivants :
- un dispositif de réception optique (eop) pour des signaux de télécommande, comportant au moins un détecteur optique de rayonnement (p), un préamplificateur (vv), un circuit décodeur (cd), un premier circuit d'évaluation (aw1), qui délivre en tant que signaux de sortie une valeur de coordonnée x et une valeur de coordonnée y (x ou y), et un second circuit d'évaluation (aw2), qui délivre en tant que signaux de sortie des signaux décodés de télécommande (ci, c1, c2, ck),

caractérisé par les caractéristiques suivantes :
- la télécommande positionnelle produit, côté transmetteur, trois signaux de télécommande dépendant de la position ( = signaux de position) (X, Y, Z), qui dépendent de l'orientation relative, prédéterminée manuellement, du transmetteur de télécommande en direction du récepteur de télévision, et
- dans la voie de transmission des trois signaux de position (X, Y, Z), convertis en des signaux de composantes électriques (kx, ky, kz), est inséré respectivement un circuit de filtre adaptatif (fx, fy, fz) servant à supprimer des composantes de fréquences supérieures de la composante respective de signal (kx, ky, kz), la fréquence limite respective étant commandée par les composantes associées de signaux.

**10.** Récepteur de télévision selon la revendication 9, caractérisé par les caractéristiques suivantes :
- la fréquence limite du circuit de filtre adaptatif (fx, fy, fz) dans la voie respective de transmission des signaux dépend de la valeur d'entrée et de la valeur de sortie du circuit de filtre adaptatif respectif,

- à partir d'une valeur d'entrée instantanée Ii et d'une valeur de sortie isochrone Io du circuit de filtre adaptatif respectif (fx, fy, fz) est formée la valeur initiale suivante Io + 1 conformément à la première règle de dimensionnement :

$$Io + 1 = (1-K)Io + KIi,$$

le coefficient K du filtre est un facteur de pondération, qui ne dépasse pas la valeur "l" et qui est formé à partir de la valeur d'entrée instantanée Ii et de la valeur de sortie isochrone Io conformément à la seconde formule suivante de dimensionnement :

K = (K max - K min) * valeur absolue de-(Ii-Io)/I max + K min,

- les valeurs K max et K min représentent les limites inférieure et supérieure de zone, qui doivent être prédéterminées, pour le coefficient de filtre K,
- la valeur I max est la limite supérieure de zone, qui doit être prédéterminée, de la valeur d'entrée respective Io du filtre, et
- l'intervalle de temps entre la valeur de sortie isochrone et la valeur de sortie suivante Io, Io + 1 du circuit de filtre adaptatif respectif fx, fy, fz est égale au moins à la durée de la période d'un cycle complet d'exploration des trois signaux de position X, Y, Z.

eop
aw1
pr
cd
kx
X
Y
Z
C
p
vv
f
cu
A
D
fx
di
gx
$x_{max}$
x
z
x
kz
fz
dr
gy
z
y
y
a1
ky
fy
di
$y_{max}$
$I_i$
$I_o$
cs
a2
kc
m
cl
cl
aw2
tg
ci
c1
c2
ck
fx, fy, fz
$I_i$
m1
K
ad
dt
$I_o$
m2
1-K

FIG.4a

FIG.1

zg1
s1
br
zg2
Vn
s2
ed
ec
bs
v
v
h
h
d
x,y
x,y
cg
c1
c2
pr
kx
ky
kz

FIG.2

cl
x'
ad1
v
h
mr
h
Vd
v
zv
tg
ip
cl
y'
ad2
cl
Vz

FIG. 3a

bz
0
250
750
1000
x
0
25
50
100
x'
xc
25
Vz
0
1000

FIG.3b

cr
TV
a)
ymax
xc
rr
rk
y
ymin
xmin
x
b)
xmax
HELP
Contr
Vol
c)
d)
e)
FIG.5
Ii , Io
A
II
1.)
B
I
t
2.)
K
B
A
t
3.)
T
B
A
t
4.)
fg
B
A
t
FIG.4b